# EUROPÄISCHE PATENTSCHRIFT

(11) **EP 0 746 039 B1**
(45) Veröffentlichungstag und Bekanntmachung des Hinweises auf die Patenterteilung: **11.12.2002**
(21) Anmeldenummer: 96108435.7
(22) Anmeldetag: 28.05.1996
(51) Int. Cl.: H01L 29/735

(54) **Bipolartransistor vom pnp-Typ**
PNP type bipolar transistor
Transistor bipolaire de type PNP

(30) Priorität: 01.06.1995 DE 19520182
(43) Veröffentlichungstag der Anmeldung: 04.12.1996
(73) Patentinhaber: Infineon Technologies AG, 81669 München (DE)
(72) Erfinder: Müller, Karlheinz, Ing., 84478 Waldkraiburg (DE); Pöhle, Holger, Dipl.-Ing., 82024 Taufkirchen (DE)
(74) Vertreter: Müller - Hoffmann & Partner

(56) Entgegenhaltungen:
- EP-A- 0 005 728
- EP-A- 0 619 610
- US-A- 4 125 853
- US-A- 5 070 381
- US-A- 5 347 156
- PATENT ABSTRACTS OF JAPAN vol. 6, no. 67 (E-104), 28.April 1982 & JP-A-57 007157 (FUJITSU LTD), 14.Januar 1982,

## Beschreibung

Die Erfindung betrifft einen Bipolartransistor vom pnp-Typ mit einer hochdotierten p-leitenden Emitterzone, einer Basiszone und einer Kollektorzone sowie einer vergrabenen n-leitenden Zone, die unterhalb der Emitterzone angeordnet ist, und mit einer Kollektorzone, die eine hochdotierte Kollektoranschlußzone und einen von dieser bis zur vergrabenen Zone reichenden Bereich vom p-Leitfähigkeitstyp enthält, wobei die Basiszone lateral zwischen Emitter- und Kollektorzone und oberhalb der vergrabenen Zone und diese kontaktierend angeordnet ist.

Die Struktur von Bipolartransistoren ist unter anderem aus der Veröffentlichung D. Widmann, H. Mader, H. Friedrich: Technologie integrierter Schaltungen, Springer-Verlag, 1988 bekannt. Entsprechend wie die dort detailliert dargestellten npn-Transistoren werden pnp-Transistoren mit-einer hochdotierten p-leitenden Emitterzone, einer Basiszone und einer Kollektorzone sowie einer vergrabenen n-leitenden Zone, die unterhalb der Emitterzone angeordnet ist, hergestellt. Typischerweise ist die hochdotierte p-leitende Emitterzone, die über ein Kontaktloch mit einer metallischen Leiterbahn verbunden ist, von einer p-leitenden Kollektorzone umgeben, die ebenfalls über Kontaktbereiche mit metallischen Leiterbahnführungen verbunden ist. Die Emitterzone und die Kollektorzone sind in einer n-leitenden, als Basis dienenden Wanne angeordnet und durch Isolationszonen, beispielsweise durch eine LOCOS-Isolation voneinander isoliert. Die als Basis dienende n-Wanne ist von einer hochdotierten n-leitenden vergrabenen Zone unterlegt und in lateraler Richtung von einem hochdotierten n-leitenden Graben umgeben, der von der Kollektorzone isoliert ist und mit einer durch ein Kontaktloch hergestellten metallischen Leiterbahn verbunden ist. Die hochdotierten n-leitenden Zonen der vergrabenen Zone und des Grabens bewirken dabei eine niederohmige Kontaktierung der n-Basiswanne.

In einem derartigen lateralen pnp-Transistor spaltet sich ein vom Emitter injizierter Löcherstrom in einen Nutzanteil und einen Parasitäranteil auf. Der Nutzanteil fließt durch die Basis in lateraler Richtung zur Kollektorzone, während der Parasitäranteil typischerweise im wesentlichen in vertikaler Richtung durch die vergrabene Zone in das ebenfalls p-leitende Substrat fließt. Physikalisch bedeutet das, dass unter dem Emitter durch das Driftfeld Löcher entstehen, die mit Elektronen der Basis und der vergrabenen Zone rekombinieren. Damit muss ein Basisstrom aufgebracht werden, der parasitäre Anteile enthält. Insgesamt ergibt sich deshalb für den lateralen pnp-Transistor eine niedrige Stromverstärkung und ein niedriger maximaler Kollektorstrom.

Im einzelnen sind Bipolartransistoren der eingangs genannten Art unter anderem aus Patent Abstracts of Japan, vol. 6, no. 67 (E-104), 28. April 1982 & JP-A-57007157, US-A-4125853, EP-A-0005728. US-A-5347156, US-A-5070381 und EP-A-0619610 bekannt; bei den aus US-A-5347156 und US-A-5070381 bekannten Bipolartransistoren ist dabei unterhalb der Kollektorzone noch ein schwächer dotierter Bereich des gleichen Leitungstyps wie die Kollektorzone vorgesehen.

Der Erfindung liegt die Aufgabe zugrunde, einen pnp-Transistor anzugeben, der verbesserte Eigenschaften hat.

Diese Aufgabe wird bei einem Bipolartransistor der eingangs genannten Art erfindungsgemäß dadurch gelöst, dass unterhalb von der Emitterzone ein weiterer, mit der hochdotierten Emitterzone verbundener Bereich vom p-Leitfähigkeitstyp zwischen der hochdotierten Emitterzone und der vergrabenen Zone angeordnet ist, und dass der weitere Bereich mindestens zwei Grössenordnungen niedriger als die hochdotierte Emitterzone dotiert ist.

Ausgestaltungen der Erfindung sind in den Unteransprüchen gekennzeichnet.

Die Erfindung wird nachfolgend anhand eines in den Figuren der Zeichnung dargestellten Ausführungsbeispiels näher beschrieben. Es zeigen:
- FIG 1: einen schematischen Querschnitt durch den erfindungsgemäßen pnp-Transistor,
- FIG 2: einen schematischen Querschnitt durch einen zweiten erfindungsgemäßen pnp-Transistor,
- FIG 3: ein Ersatzschaltbild der Transistorstruktur nach FIG 2,
- FIG 4: einen schematischen Querschnitt durch einen dritten erfindungsgemäßen pnp-Transistor, und
- FIG 5: ein schematisches Diagramm zur Darstellung der Stromverstärkung als Funktion des Kollektorstroms.

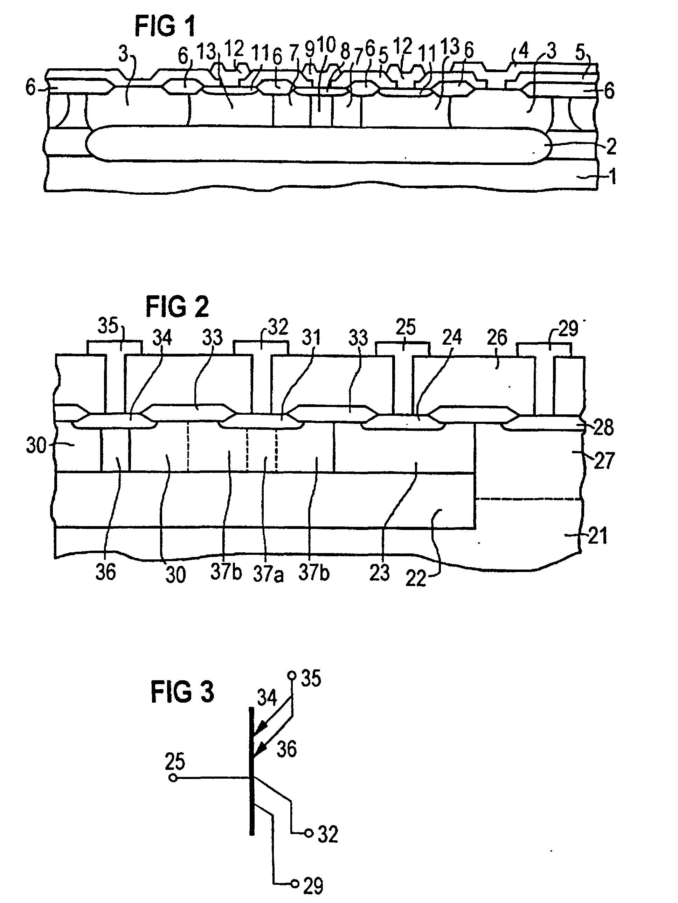

Gemäß FIG 1 ist in einem p-leitenden Substrat eine hochdotierte n-leitende Zone 2 angeordnet. Die Zone 2 ist im Außenbereich über eine ringförmige Grabenzone 3 mit der Oberfläche der Halbleiteranordnung verbünden. Die Zone 3 ist ebenfalls n-leitend und hochdotiert. Eine metallische Leiterbahn 4 reicht durch ein Kontaktloch in einer Isolationsschicht 5 bis auf die leitende Zone 3. Die Leiterbahn 4 stellt die Basiszuführung dar und die Zonen 2 und 3 dienen für einen niederohmigen Anschluß der Basis. Die hochdotierten Zonen 3 sind an der Oberfläche der Halbleiteranordnung durch Isolationsbereiche 6, die beispielsweise eine LOCOS-Isolation darstellen, von benachbarten Bereichen isoliert.

Schematisch ist angedeutet, daß sich außerhalb des durch die Zonen 2 und 3 definierten Gebietes weitere Transistorstrukturen anschließen, beispielsweise in einer BICMOS-Technologie. So kann außerhalb der n-leitenden Zone 3 eine hochdotierte p-leitende laterale Schicht vorgesehen sein, von der ein nur andeutungsweise dargestellter p-leitender Grabenbereich bis unter die in diesem Bereich vorhandene LOCOS-Isolation 6 reicht.

Innerhalb des durch die Zonen 2 und 3 definierten Gebiet befindet sich die n-leitende Basis 7. In Richtung zur Oberfläche der Halbleiteranordnung ist die Basis 7 mit einer hochdotierten p-leitenden Emitterzone 8 verbunden, die über ein Kontaktloch in der Isolationsschicht 5 mit einer metallischen Leiterbahn 9 für den Emitteranschluß kontaktiert ist.

Zwischen der hochdotierten Emitterzone 8 und der vergrabenen Zone 2 ist ein weiterer p-leitender Bereich 10 angeordnet, der pfeilerförmig ausgebildet ist. Der pfeilerförmige Bereich 10 reicht von der hochdotierten Emitterzone 8 bis zur vergrabenen Zone 2. Wie in dem Querschnitt der FIG 1 gezeigt, ist der pfeilerförmige weitere Bereich 10 unterhalb der hochdotierten Emitterzone derart angeordnet, daß seine äußeren Grenzbereiche zur n-dotierten Basis 7 innerhalb des durch die Außenabmessungen der hochdotierten Emitterzone 8 definierten Bereichs liegen. In der gezeigten Anordnung bildet deshalb die hochdotierte Emitterzone ein Kapitell für den pfeilerförmigen weiteren Bereich 10.

Die Dotierung der Emitterzone 8 beträgt etwa 10²⁰ bis 10²¹ cm⁻³, - und die Dotierung des weiteren Bereichs 10 liegt etwa im Bereich von 10¹⁶ bis 10¹⁸ cm⁻³.

Zwischen dem Emitterbereich mit der hochdotierten Emitterzone 8 und des weiteren Bereichs 10 sowie der grabenförmigen Basiszone 3 ist die Kollektorzone 12 angeordnet, die ringförmig oder in der Draufsicht offen geformt sein kann, und die jeweils durch beispielsweise LOCOS-Bereiche 6 von den Zonen 3 und 8 isoliert ist. Die Kollektorzone 11 wird über ein Kontaktloch in der Isolationsschicht 5 mit einer metallischen Leiterbahn 12 kontaktiert. Im Ausführungsbeispiel 1 ist unterhalb der Kollektorzone 11 eine p-dotierte Wanne 13 als Kollektor vorgesehen. Der Kollektor 13 ist dabei über die hochdotierte Kollektorzone 11 mit der Leiterbahnzuführung 12 verbunden.

Dadurch, daß unterhalb der hochdotierten Emitterzone 8 ein weiterer p-dotierter Bereich 10 ausgebildet ist, verringert sich innerhalb der Basis die bei Anordnungen nach dem Stand der Technik bekannte Löcherwolke, so daß weniger Löcher mit Elektronen der Basis bzw. der vergrabenen Zone 2 rekombinieren. Dadurch sinkt der Basisstrom und es ergibt sich eine höhere Stromverstärkung. Die Erhöhung der p-Konzentration im Emitterbereich ermöglicht weiterhin insbesondere bei großen injizierten Strömen einen größeren maximalen Kollektorstrom. Die Herstellung des p-leitenden weiteren Bereichs 10 kann in ähnlicher Weise wie der Wannenbereich 13 erfolgen, d.h. mit Hilfe einer Maskentechnik erfolgt eine Implantation mit nachfolgendem Ausheilschritt. Eine Prozeßänderung des benutzten Prozesses ist nicht notwendig, sondern lediglich eine Maskenänderung.

FIG 2 zeigt in stark schematisierter Darstellung ausschnittweise im Querschnitt eine weitere Ausführung eines bipolaren pnp-Transistors. In einem Substrat 21 von p-Leitfähigkeit ist eine vergrabene Zone 22 angeordnet, die über einen hochdotierten n-leitenden Grabenbereich 23 mit einer hochdotierten n-leitenden Basiszone 24 verbunden ist. Die hochdotierte Basisanschlußzone 24 ist mit einer metallischen Basiszuführung 25 kontaktiert, die über ein Kontaktloch in einer Isolationsschicht 26 bis auf die Basisanschlußzone 24 reicht. Das Substrat 21 ist über eine p-leitendene Schicht 27 mit einer hochdotierten p-leitenden Zone 28 verbunden, die mit einer metallischen Leiterbahn 29 über ein Kontaktloch in der Isolationsschicht 26 kontaktiert ist. Die Bereiche 28 und 29 bilden den Substratanschluß der Transistoranordnung.

In der durch die Zonen 22 und den grabenförmigen Anschluß 23 gebildeten Wanne befindet sich die n-leitende Basis 30. In lateraler Richtung zwischen der Basis und der Basisanschlußzone 24 ist die hochdotierte p-leitende Kollektoranschlußzone 31 vorgesehen, die über eine metallische Kollektorzuführung und ein Kontaktloch in der Isolationsschicht 26 kontaktiert ist. Die Kollektoranschlußzone 31 ist beidseitig durch beispielsweise eine LOCOS-Isolation 33 einerseits zur Basisanschlußzone 24 isoliert und andererseits zur hochdotierten Emitterzone 34, die innerhalb der Basis 30 angeordnet ist. Die hochdotierte Emitterzone 34 ist mit einer metallischen Emitterzuführung 35 über ein Kontaktloch in der isolierenden Schicht 26 verbunden.

Der weitere p-leitende Emitterbereich 36 ist pfeilerförmig unterhalb des hochleitenden Emitterbereichs 34 derart angeordnet, daß die Zone 34 ein Kapitell für den Pfeiler 36 bildet. Das bedeutet, wie in FIG 2 dargestellt, daß im Querschnitt die Pfeilerbreite der Zone 36 schmaler als die Breite der Zone 34 ist. Die Breite des Pfeilers wird dabei so eingestellt, daß sich die bei angelegter Spannung aufgrund der Kollektor-Emitter-Spannung bildende Raumladungszone zwischen dem weiteren Emitterbereich 36 und der angrenzenden Basis 30 nicht über den äußeren Rand der hochdotierten Emitterzone 34 hinaus erstreckt. Die Einstellung einer derartigen Pfeilerbreite der weiteren Zone 36 hängt vom jeweiligen Herstellungsprozeß ab und ist dem Fachmann geläufig. Dadurch, daß demzufolge der wirksame Emitterbereich wie bei bisherigen Strukturen auch durch die hochdotierte Zone 34 bestimmt wird, entspricht die Kollektor-Emitter-Durchbruchsspannung derartigen bekannten Strukturen und wird im wesentlichen durch die Zonen 34 und 31 bestimmt.

Die Zonen 37a oder alternativ 37b geben Möglichkeiten an, unterhalb der Kollektorzone 31 eine Kollektorwanne zu erzeugen. Wie in der FIG durch gestrichelte Linien angedeutet, wird dadurch in jedem Fall der Basisbereich 30 schmaler. Für die p-dotierte Kollektorwanne kommt ähnlich wie bei den Emitter ein pfeilerartiger Bereich 37a in Frage oder eine breiter als die hochdotierte Kollektorzone 31 ausgebildete Wanne 37b. Der Vorteil dieser Anordnung besteht in einer verbesserten Stromergiebigkeit (besserer Löchertransport).

FIG 3 gibt ein Ersatzschaltbild der Anordnung nach FIG 2 an. Der Emitter wirkt dabei ausgehend vom Emitterkontakt 35 als Zweifachemitter mit der hochdotierten Emitterzone 34 und dem weiteren pfeilerförmigen Emitterbereich 36.

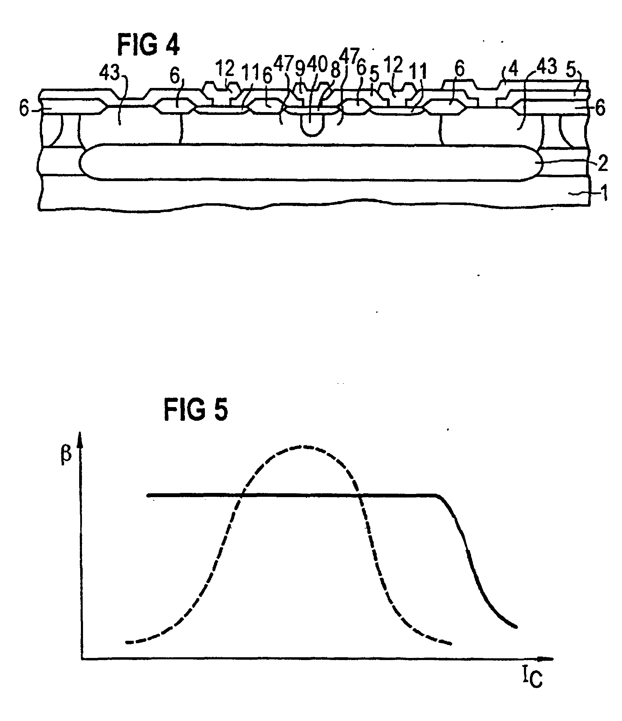

FIG 4 zeigt ein drittes Ausführungsbeispiel, das sich von dem Beispiel der FIG 1 im wesentlichen dadurch unterscheidet, daß eine über der vergrabenen n-leitenden Zone 2 liegende als Basis dienende Epitaxieschicht 47 dicker ist als die Zone 7. Dementsprechend ist die Grabenzone 43 dicker als Zone 3. Eine Kollektorwanne unterhalb der Kollektorzone, vgl. Wanne 13 in FIG 1, ist nicht vorgesehen. Der weitere Bereich 40 unterhalb der hochdotierten Emitterzone 8 ist nicht pfeilerförmig, sondern napfförmig ausgebildet und reicht ausgehend von der Emitterzone 8 nicht bis zur vergrabenen Zone 2 hinunter. Die Tiefe des weiteren napfförmigen Bereichs 40 reicht vorzugsweise von der Emitterzone 8 bis über die halbe Dicke der Epitaxieschicht 47 hinaus.

FIG 5 zeigt in schematischer Form die Stromverstärkung β in Abhängigkeit vom Kollektorstrom I_{C}. Die durchgezogene Linie zeigt eine nahezu konstante Stromverstärkung bis zu hohen Kollektorströmen. Die gestrichelte Linie zeigt die Funktion β (I_{C}) für bekannte Transistorstrukturen. Der erfindungsgemäße Bipolartransistor ermöglicht deshalb sowohl eine gleichmäßige Stromverstärkung als auch erheblich höhere Kollektorströme als bekannte Anordnungen. Die Größenanordnung der Kollektorstromerhöhung beträgt bei den Ausführungsbeispielen zwischen 10 % und etwa 20 %.

## Patentansprüche

1. Bipolartransistor vom pnp-Typ
mit einer hochdotierten p-leitenden Emitterzone (8), einer Basiszone (7) sowie einer vergrabenen n-leitenden Zone (2), die unterhalb der Emitterzone (8) angeordnet ist, und
mit einer Kollektorzone, die eine hochdotierte Kollektoranschlußzone (11; 31) und einen von dieser bis zur vergrabenen Zone (2; 22) reichenden Bereich (13; 37) vom p-Leitfähigkeitstyp enthält, wobei die Basiszone (7) lateral zwischen Emitter- und Kollektorzone und oberhalb der vergrabenen Zone (2) und diese kontaktierend angeordnet ist,
**dadurch gekennzeichnet, daß**
unterhalb von der Emitterzone (8) ein weiterer, mit der hochdotierten Emitterzone verbundener Bereich (10; 36) vom p-Leitfähigkeitstyp zwischen der hochdotierten Emitterzone (8; 34) und der vergrabenen Zone (2; 22) angeordnet ist, und
daß der weitere Bereich (10; 36) mindestens zwei Größenordnungen niedriger als die hochdotierte Emitterzone (8) dotiert ist.

2. Bipolartransistor nach Anspruch 1,
**dadurch gekennzeichnet,**
**daß** der weitere Bereich pfeilerförmig unterhalb der hochdotierten Emitterzone ausgebildet ist.

3. Bipolartransistor nach Anspruch 1,
**dadurch gekennzeichnet,**
**daß** der weitere Bereich napfförmig unterhalb der hochdotierten Emitterzone ausgebildet ist.

4. Bipolartransistor nach einem der Ansprüche 1 bis 3,
**dadurch gekennzeichnet,**
**daß** die Breite des weiteren Bereichs im Querschnitt geringer als diejenige der hochdotierten Emitterzone ist.

5. Bipolartransistor nach einem der Ansprüche 1 bis 4,
**dadurch gekennzeichnet,**
**daß** der weitere Bereich (10; 36) die hochdotierte Emitterzone (8; 34) mit der vergrabenen Zone (2; 22) verbindet.

6. Bipolartransistor nach einem der.Ansprüche 1 bis 5,
**dadurch gekennzeichnet,**
**daß** die vergrabene Zone (2; 22) über eine hochdotierte n-leitende Zone (3; 23) mit einem Basisanschluß (4; 24, 25) des Transistors verbunden ist.

## Claims

1. pnp-type bipolar transistor
having a heavily doped p-type emitter zone (8), a base zone (7) plus a buried n-type zone (2) arranged beneath the emitter zone (8), and having a collector zone that contains a heavily doped collector-contact zone (11; 31) and a region (13; 37) of p-type conductivity extending from this zone to the buried zone (2; 22), the base zone (7) being arranged laterally between emitter zone and collector zone and above the buried zone (2), and lying in contact with these,
**characterized in that**
an additional region (10; 36) of p-type conductivity connected to the heavily doped emitter zone is arranged beneath the emitter zone (8), between the heavily doped emitter zone (8; 34) and the buried zone (2; 22), and
**in that** the additional region (10; 36) has a doping level that is at least two orders of magnitude less than the heavily doped emitter zone (8).

2. Bipolar transistor according to Claim 1,
**characterized in that**
the additional region is formed in the shape of a pillar beneath the heavily doped emitter zone.

3. Bipolar transistor according to Claim 1,
**characterized in that**
the additional region is formed in the shape of a bowl beneath the heavily doped emitter zone.

4. Bipolar transistor according to one of Claims 1 to 3,
**characterized in that**
the width of the additional region is narrower in cross-section than that of the heavily doped emitter zone.

5. Bipolar transistor according to one of Claims 1 to 4,
**characterized in that**
the additional region (10; 36) connects the heavily doped emitter zone (8; 34) to the buried zone (2; 22).

6. Bipolar transistor according to one of Claims 1 to 5,
**characterized in that**
the buried zone (2; 22) is connected to a base contact (4; 24, 25) of the transistor via a heavily doped n-type zone (3; 23).

## Revendications

1. Transistor bipolaire de type pnp
comprenant une zone (8) d'émetteur très dopée de conductivité p, une zone (7) de base, ainsi qu'une zone (2) enterrée de conductivité n qui est disposée en dessous de la zone (8) d'émetteur, et une zone de collecteur qui comporte une zone (11 ; 31) très dopée de borne de collecteur et une partie (13 ; 37) de type de conductivité p allant de cette zone jusqu'à la zone (2 ; 22) enterrée, la zone (7) de base étant disposée latéralement entre la zone d'émetteur et la zone de collecteur et au-dessus de la zone (2) enterrée en étant en contact avec celle-ci,
**caractérisé**
**en ce qu'**il est disposé en dessous de la zone (8) d'émetteur, entre la zone (8 ; 34) d'émetteur très dopée et la zone (2 ; 22) enterrée, une autre partie (10 ; 36) de type de conductivité p qui est reliée à la zone très dopée d'émetteur, et en ce que l'autre partie (10 ; 36) est moins dopée d'au moins deux ordres de grandeur que la zone (8) très dopée d'émetteur.

2. Transistor bipolaire suivant la revendication 1,
**caractérisé**
**en ce que** l'autre partie est constituée en forme de flèche en dessous de la zone très dopée d'émetteur.

3. Transistor bipolaire suivant la revendication 1,
**caractérisé**
**en ce que** l'autre partie est constituée en forme de godet en dessous de la zone très dopée d'émetteur.

4. Transistor bipolaire suivant l'une des revendications 1 à 3,
**caractérisé**
**en ce que** la largeur de l'autre partie est en section transversale plus petite que celle de la zone très dopée d'émetteur.

5. Transistor bipolaire suivant l'une des revendications 1 à 4,
**caractérisé**
**en ce que** l'autre partie (10 ; 36) relie la zone (8 ; 34) très dopée d'émetteur à la zone (2 ; 22) enterrée.

6. Transistor bipolaire suivant l'une des revendications 1 à 5,
**caractérisé**
**en ce que** la zone (2 ; 22) enterrée est reliée à une borne (4 ; 24, 25) de base du transistor par une zone (3 ; 23) très dopée de conductivité n.
